# EUROPEAN PATENT SPECIFICATION

(11) **EP 3 529 398 B1**
(45) Date of publication and mention of the grant of the patent: **19.10.2022**
(21) Application number: 17787197.7
(22) Date of filing: 24.10.2017
(51) Int. Cl.: C25D 5/18, C25D 5/14, C23C 18/16, H01R 13/03, C25D 5/12, C25D 5/00

(54) **A METHOD OF DEPOSITING A TIN LAYER ON A METAL SUBSTRATE AND A USE OF A STRUCTURE COMPRISING A NICKEL/PHOSPHOROUS ALLOY UNDERLAYER AND SAID TIN LAYER OBTAINED WITH SAID METHOD**
VERFAHREN ZUM AUFBRINGEN EINER ZINNSCHICHT AUF EIN METALLSUBSTRAT UND VERWENDUNG EINER STRUKTUR MIT EINER UNTERSCHICHT AUS NICKEL-PHOSPHOR-LEGIERUNG UND BESAGTER ZINNSCHICHT MIT DEM BESAGTEN VERFAHREN
PROCÉDÉ DE DÉPÔT D'UNE COUCHE D'ÉTAIN SUR UN SUBSTRAT MÉTALLIQUE ET UTILISATION D'UNE STRUCTURE COMPRENANT UNE SOUS-COUCHE D'ALLIAGE DE NICKEL/PHOSPHOREUX ET LADITE COUCHE D'ÉTAIN SELON LEDIT PROCÉDÉ

(30) Priority: 24.10.2016 EP 16195351
(43) Date of publication of application: 28.08.2019
(73) Proprietor: Atotech Deutschland GmbH & Co. KG, 10553 Berlin (DE)
(72) Inventor: NEOH, Din-Ghee, 10553 Berlin (DE); TAN, Chee-Chow, 10553 Berlin (DE); LIM, Jen Joo, 10553 Berlin (DE); RÜTHER, Robert, 10553 Berlin (DE); BARTHELMES, Jürgen, 10553 Berlin (DE); KURTZ, Olaf, 10553 Berlin (DE)
(74) Representative: Atotech Deutschland GmbH & Co. KG
(86) International application number: PCT/EP2017/077156
(87) International publication number: WO 2018/077874

(56) References cited:
- EP-A1- 1 257 004
- JP-A- 2005 109 373
- JP-A- 2006 307 328
- JP-A- 2008 218 318

## Description

### Field of the Invention

The present invention refers to depositing a tin layer on a metal substrate, in particular on a copper or copper alloy substrate, while preventing pressure induced whisker formation. Such tin layers are used in the manufacture of electronic circuits in electronic devices, more specifically of electrical connectors and integrated circuit lead frames.

### Background of the invention

In electronic devices conductor lines of an electronic circuit and contact elements, such as sliding and contact bows, are generally final coated with corrosion/oxidation resistance coatings, typically made of metal. The conductor lines are usually made of copper, and the contact elements are usually made of copper, brass, or other copper alloys, such as copper/nickel/tin. These final coatings prevent oxidation of the base metal in order to preserve solderability and maintain low electrical contact resistance thereof, especially for electrical connector applications. Furthermore, the final coatings are required to present reduced inserting forces in electrical connector applications, in engagement of a male terminal and a female terminal formed by press working of plating materials for example. The final coatings generally consist of tin or tin alloys. Previously, tin/lead alloys have been used as the tin alloys. Due to environmental requirements however, the use of lead has been ceased to be employed. Therefore, pure tin is frequently utilized as a corrosion/oxidation resistance layer in such applications.

It has proved problematic that pure tin is subject to whisker formation, especially to pressure induced whisker formation. Whiskers consist of elongated structures of tin metal which project from the tin surface. They may present problems in electronic devices due to creating short circuits between adjacent conductor lines or between adjacent contact elements and due to creating raised gliding resistance as a result of increased surface roughness. Pressure induced whisker formation is especially found in electrical connector applications, where the male and female terminal elements are pressed together and this pressure causing the whiskers to form.

Great efforts have been made to overcome these drawbacks of pure tin layers, in particular for corrosion induced tin whiskers or whiskers induced by formation of intermetallic compounds. However, pressure induced whiskers did not get as much attention as other types of whiskers.

For example, EP 2 759 622 A1 describes a metal material for an electronic component which has low whisker formability and high durability. The metal material comprises a base material, such as copper or copper alloy, a surface layer which is formed of tin, indium, or an alloy thereof, a middle layer provided between the base material and the surface layer which is formed of silver, gold, platinum, palladium, ruthenium, rhodium, osmium, iridium, or an alloy thereof and optionally an underlayer provided between the base material and the middle layer which is formed of one or two metals selected from the group consisting of nickel, chromium, manganese, iron, cobalt, and copper.

US 6,361,823 B1 describes a process for aqueous electroless tin plating on copper or copper alloy surfaces. This process preserves solderability and inhibits tin whisker growth. It comprises immersion plating of pure tin on the copper or copper alloy surface and immersion plating of an alloy of at least two metals selected from tin, silver, bismuth, copper, nickel, lead, zinc, indium, palladium, platinum, gold, cadmium, ruthenium, and cobalt, more particularly a tin/lead alloy, a tin/indium alloy, a tin/bismuth alloy, a tin/indium/silver alloy, a tin/silver alloy, or a silver/indium alloy.

JP 2007/284762 A describes a method for forming a tin-plated film in semiconductor manufacturing while preventing whiskers from forming on the film and simultaneously achieving that the film adheres to the base material. This method comprises forming a tin-plated film and then forming a silver film on the tin-plated film using an electroless or electrolytic plating method.

US 2006/0292847 A1 describes a method of reducing tin whisker formation in a plated substrate that includes a surface layer comprising tin. This method comprises depositing an underlayer comprising silver or a barrier layer underneath the tin comprising layer. Such barrier layer may be a nickel barrier layer.

EP 1 257 004 A1 describes a metal article which is provided with a multilayer coating, said article being suited to be used as an electrical connector or lead frame. The multilayer coating comprises an underlayer of nickel, a nickel alloy, cobalt, or a cobalt alloy, preferably an amorphous nickel/phosphorous alloy, a middle layer of tin or a tin alloy which is subject to whisker growth, and an outer layer of palladium, rhodium, ruthenium, platinum, copper, silver, indium, bismuth, or an alloy of one or more of these metals. This outer layer is provided to inhibit whisker formation.

JP 2008218318 A relates a Pb-free wiring conductor with less risk of generation of whiskers from a Sn-plated film surface or a solder of a conductor periphery. Therein a composite material is disclosed, comprising a Pb-free Sn-based material part and a metal material serving as a core material on at least a part of the surface, and a Ni - P intermediate layer having a predetermined thickness is provided between the core material and the Sn - based material part.

JP 2005109373 A discloses a primary coat, in which a bilayer structure of an Ni layer and an NiP layer is used, wherein the occurrence of a whisker can be suppressed.

JP 2006307328 A relates to a leadless Sn-base plating film in which the growth of whiskers can be suppressed and a method to produce the film. The leadless Sn-base plating film is obtained by stacking plating layers in which metal is precipitated, and the stacked boundary between the plating layers forms a discontinuous face of the crystal growth of the metal.

The above mentioned documents relate to prevention of tin whiskers induced by corrosion, by formation of intermetallic compounds or by a thermal mismatch between metal deposit and substrate material. It has however proved that these methods and multilayers do not sufficiently inhibit formation of whiskers. In addition, none of the above mentioned documents relates to the formation of tin whiskers induced by applying external pressure. Therefore, a problem underlying the present invention is to provide an improved method of inhibiting pressure induced whisker formation. This method shall more preferably provide a method of forming a tin layer which has the required properties of preventing corrosion and oxidation of the substrate metal to which it is provided and inhibiting pressure induced whiskers of such tin layer. Even more preferably, the problem underlying the present invention comprises providing a method of depositing a pure tin layer on an electronic device while taking care of preventing pressure induced whisker formation.

### Summary of the Present Invention

It has now been discovered that pressure induced whisker formation can efficiently be inhibited by forming the tin layer using a pulse plating method and wherein the tin layer is formed as a tin deposit on a nickel/phosphorous alloy underlayer being deposited on at least one surface of said substrate.

Therefore, according to one aspect, the present invention refers to a method of depositing a tin layer on a metal substrate. This method comprises:
(a) providing said metal substrate;
(b) depositing said nickel/phosphorous alloy underlayer on at least one surface of said metal substrate; and
(c) depositing said tin layer on said nickel/phosphorous alloy underlayer, wherein said tin layer is deposited comprising using a pulse plating method wherein said pulse plating method is a unipolar pulse plating method, said unipolar pulse plating method comprising successive pulse periods each comprising a cathodic pulse section and a zero current pulse section, and wherein said cathodic pulse section has a cathodic pulse duration of at least 0.1 s and wherein said zero current pulse section has a zero current pulse duration of at least 0.1 s; wherein
   said method further comprises:
   (b1) depositing a nickel underlayer on said at least one surface of said substrate prior to depositing said tin layer in said method step (c) and
   that said nickel underlayer is deposited prior to depositing said nickel/phosphorous alloy underlayer in said method step (b); and
(d) depositing a silver or silver alloy top layer on said tin layer.

Furthermore, the description refers to the use of a structure comprising a nickel/phosphorous alloy underlayer and a pulse electroplated tin layer deposited on a metal substrate with the method of the present invention for preventing the formation of pressure induced whiskers.

Furthermore, according to a further aspect, the present invention refers to the use of the method of the present invention for the manufacture of electronic circuits in electronic devices having a tin layer free of pressure induced whiskers, determined by subjecting said tin layer to a mechanical force at a predetermined pressure for a predetermined period of time.

Accordingly, a nickel/phosphorous alloy is deposited on the at least one substrate surface and tin is deposited on said nickel/phosphorous alloy deposit, preferably by using wet chemical methods which usually comprises contacting the at least one substrate surface with a nickel/phosphorous alloy plating liquid which contains nickel and phosphorous species and with a tin plating liquid which contains tin species, whereupon the nickel/phosphorous alloy is deposited on the at least one substrate surface and tin metal is deposited on the nickel/phosphorous alloy deposit. Preferably, during these contacting steps a voltage is applied across the substrate and a counter electrode which is also brought into contact with the nickel/phosphorous alloy or tin plating liquids so that the nickel/phosphorous alloy or tin is electroplated on the at least one substrate. The nickel/phosphorous alloy may in an alternative be deposited using an electroless method.

Pulse plating is used to deposit tin on the nickel/phosphorous alloy deposit, which means that the voltage is pulsed by switching the voltage and current between at least one plating section and at least one non-plating section, wherein the at least one plating section comprises setting the voltage and current at a level at which tin metal is deposited on the nickel/phosphorous alloy deposit and wherein the at least one non-plating section comprises setting the voltage and current at a level at which tin metal deposition does not occur. In principle, the current level at which tin metal deposition does not occur in the non-plating section comprises both, a zero current level or an anodic current. Preferably, this current level is a zero current level. The pulsing regime may be very complex in that a plurality of plating and non-plating sections having different voltage and current levels are applied in each one of successive voltage and current pulse periods or very simple in that only one plating section and one non-plating section are applied. In general, a pulse plating regime is comprised of a pulse train comprising successive pulse periods which are each identical concerning the voltage or current curves and which each consist of at least one plating section and at least one non-plating section which follow each other alternatively, more preferably one plating section and one non-plating section. The pulses may have any shape with time, preferably the pulses are rectangular with time.

As the nickel/phosphorous alloy underlayer underneath the tin layer is formed and as tin is deposited by using pulse plating, pressure induced whisker formation is suppressed to a lower level than was ever achieved previously. Particularly, it is the formation of the nickel / phosphorous alloy underlayer and the pulse plating of the tin layer which basically yield the tin layer being free of pressure induced whiskers. Pressure induced whisker formation may be evaluated by measuring the extension of whiskers from their originating position. When comparing whisker formation with and without the nickel / phosphorous alloy underlayer as well as with and without pulse plating of tin, it emerges that such extension is markedly reduced so that the problems associated with whisker formation are overcome. Thus, all problems which are associated with forming whiskers are overcome, namely, forming short circuits between adjacent conductive areas and enhanced inserting forces of electrical connectors, in engagement of a male terminal and a female terminal formed by press working of plating materials for example. Thus, the method of depositing a tin layer on a metal substrate according to the present invention is preferably for suppressing formation of pressure induced tin whiskers, more preferably for forming a tin layer being free of pressure induced whiskers. Further, the method of depositing a tin layer on a metal substrate does preferably not form any defects resulting from the tin layer, more preferably does not cause any disturbances during tin deposition, even more preferably does not cause formation of tin dendrites.

Pressure induced whisker formation is attributed to mechanical stress being formed in the tin film. Such mechanical stress is induced in a tin layer by applying an external mechanical pressure. In electrical connectors, for example, pressure whiskers may be induced if they are plugged into each other. Pressure induced whisker formation is evaluated or tested by generating such whiskers by applying an external mechanical pressure to the tin layer for an extended period of time and finally measure the number and size of whiskers obtained.

Different to pressure induced whisker formation is generation of corrosion induced whiskers, of whiskers induced by formation of intermetallic compounds or by a thermal mismatch between metal deposit and substrate material.

Whisker forming conditions leading to corrosion induced whiskers comprise subjecting a sample having a tin layer to a corroding atmosphere such as humid air at elevated temperature or at room temperature for an extended period of time. Presence of e.g. chloride ions further promotes corrosion and thus further promotes formation of corrosion induced whiskers. Therefore, a means for evaluating the tendency of a tin layer to generate corrosion induced whiskers is to provoke corrosion by applying an atmosphere of 87 % relative humidity at 55 °C isothermally for 4000 hours to it. Generation of corrosion induced tin whiskers can be mitigated by treating the tin layer in an aqueous solution containing an organic phosphonic acid, such as an alkyl phosphonic acid, and a surfactant, such as a non-ionic surfactant, according to EP 2 014 798 A1.

Whiskers induced by formation of intermetallic compounds develop from tin layers deposited onto other metal surfaces, for example copper surfaces. Atoms of the other metal, e.g. copper atoms, may diffuse into the tin layer and form intermetallic compounds which in turn cause formation of tin whiskers. A means for evaluating the tendency of a tin layer to generate such whiskers is to provoke formation of an intermetallic compound by applying an atmosphere of 60 % relative humidity at 30 °C isothermally for 4000 hours to it as recommended by iNEMI (International Electronics Manufacturing Initiative). Generation of such tin whiskers can be mitigated by heat treating the tin layer for 1 hour at 150 °C as recommended by iNEMI.

Whiskers induced by a thermal mismatch develop from tin layers deposited onto substrate materials having a coefficient of thermal expansion (CTE) differing strongly from the CTE of the tin layer. An example is a tin layer deposited onto a copper substrate or onto a copper substrate having a nickel layer. Applying high temperatures, as for example when soldering, causes the materials to expand at temperature increase and contract at temperature decrease. Due to the strongly differing CTEs of tin and its substrate, compressive stress is effected in the tin layer which in turn causes formation of tin whiskers. A means for evaluating the tendency of a tin layer to generate such whiskers is to provoke thermal stress by temperature cycling from -55 °C to +85 °C during 1000 cycles.

Tin plating defects having remote similarity with whiskers are so called dendrites. Tin dendrites are filament like or tree like structures projecting from a tin deposit. They have a fractal and polycrystalline structure, while tin whiskers have a monocrystalline structure. Dendrites and whiskers can be readily distinguished under the microscope because of specific striations being typical for the monocrystalline character of whiskers. Dendrites grow during electrodepositing tin; they need electrical current to grow and growth stops when electrodepositing stops. In contrast, tin whiskers start to form as recently as electrodeposition is finished and growth requires an expanded period of time after electrodeposition. Thus, dendrites can be detected directly after deposition of tin, while this is not possible for detecting whiskers. Tin dendrites are caused by inhomogeneities of the surface of the substrate to be tin plated, by insufficient or wrong pretreatment of the substrate surface prior to tin plating, by poor wetting of the substrate surface or by unsuitable composition of the tin plating solution or unsuitable conditions for plating. In contrast, tin whiskers are caused by a number of stresses developing within the already deposited tin layer as described above. Thus, tin dendrites and tin whiskers are a very different kind of defect.

It has been found that different means are available and necessary to mitigate pressure induced whisker formation on the one hand and whiskers induced by other phenomena on the other hand. The different avoiding means have proved not to be suitable for the respective other type of whiskers. Therefore, methods to prevent corrosion induced whisker formation or whiskers induced by formation of intermetallic compounds have found out not to be suitable at all to avoid pressure induced whisker formation. This is shown by Examples 10 and 11 herein. This might be due to the fact that the named types of whiskers are completely different phenomena which need different measures to prevent same.

According to the present invention, the tin layer deposited in step (c) is deposited after the nickel/ phosphorous alloy underlayer is deposited in step (b). The tin layer furthermore ensures good solderability of the substrate, which may be a circuit line or a contact element, for example a sliding bow or contact bow. The tin layer prevents substrate corrosion/oxidation which might take place due to oxidation thereof, while forming a copper oxide surface layer for example.

### Detailed Description of the Present Invention

The limits of the ratios and ranges disclosed herein may be combined. For example if a range of 30-100 is disclosed, and a range of 50 to 70 is disclosed, the ranges of 30-70 and 70-100 are deemed to be disclosed.

Specific embodiments of the invention are given below. The embodiments can be performed singly or in any combination.

The substrate to be provided with the nickel/phosphorous alloy and tin layers is preferably made of copper, brass, bronze, nickel silver or any other copper alloy, such as copper/nickel/tin. The substrate may also be made of steel or aluminum. The substrate may be a contact element, a male or female terminal of a contact element pair for example, a printed circuit board comprising circuit lines e.g. made of copper, or a lead frame having metal contacts or any other electrical element to be provided with a tin plating layer. Contact elements may be press fit connectors, flexible flat cable (FFC) connectors, or flexible printed circuit (FPC) connectors.

Tin is deposited using a wet chemical metal deposition method, including bringing the at least one substrate surface into contact with a tin plating liquid and letting an electric current flow so that tin ions are discharged at the at least one substrate surface (being coated with the nickel / phosphorous alloy deposit) to become tin metal which forms a tin layer on the nickel / phosphorous alloy deposit.

The tin plating liquid is preferably a tin plating solution. The plating solution contains tin ion species and a solvent. Furthermore preferably, the plating solution may include ionic material imparting the plating solution enhanced electrical conductivity. Furthermore preferably, the plating solution may include pH adjusting material. Furthermore, preferably, the plating solution may comprise further components, like surfactants to enhance wetting of the at least one substrate surface with the plating solution and to increase solubility of components contained in the plating solution, further components imparting the plating solution improved stability against decomposition, and other components imparting the tin layer improved properties, like mechanical and electrical properties.

One or more solvents may be contained in the plating solution. The plating solution preferably contains water as one of the solvents. If water is contained in the plating solution as a major solvent component (at least 50 vol.-%) the tin plating solution is to be considered an aqueous plating solution. Additionally organic solvents may be contained in the plating solution, such as alcohols and/or ethers, like alcohol ethers.

The tin ion species may be any tin ions constituting part of tin salts, like inorganic or organic tin salts, tin sulfate, tin nitrate, tin chloride, tin bromide, tin acetate, tin methanesulfonate, or tin sulfamate (tin salt of amidosulfuric acid) for example. Tin may be present as a tin(II) ion species and/or tin(IV) ion species, i.e., tin salts are either tin(II) salts or tin(IV) salts or a mixture of tin(II) salts and tin(IV) salts. Tin(IV) ion species or tin(IV) salts are tin ion sources being preferably contained in strong alkaline tin plating solutions.

The ionic material imparting the plating solution enhanced electrical conductivity may be any inorganic or organic salt which readily dissociates in ionic species in the plating solution, preferably aqueous plating solution. This ionic material does not participate in tin deposition so that none of the constituents thereof is co-deposited together with tin to form the tin layer. The inorganic or organic salt imparting the plating solution enhanced electrical conductivity may be an alkali salt, sodium, potassium, or other alkali salt for example, of an inorganic or organic anion, such as a sulfate, nitrate, phosphate, chloride, bromide, acetate, methanesulfonate, sulfamate and/or the like. Likewise such salt may be an earth alkaline salt, a magnesium, calcium or other earth alkaline salt for example, of any one of these anions. More preferably, the ionic material imparting the plating solution enhanced electrical conductivity may be an inorganic or organic acid, i.e., a compound which produces, by dissociation, hydronium or other protonated solvent ions in the plating solution, such as a mineral acid like sulfuric acid, phosphoric acid, hydrochloric acid, hydrobromic acid and/or the like; tetrafluoroboric acid; acetic acid, methanesulfonic acid, or sulfamic acid (amidosulfuric acid) and the like. Tetrafluoroboric acid preferably is contained in strong acidic tin plating solutions.

The pH adjusting material may be any acid, base or buffer mixture, including a mineral acid such as sulfuric acid, phosphoric acid, hydrochloric acid, and/or hydrobromic acid; tetrafluoroboric acid; acetic acid, methanesulfonic acid, sulfamic acid; bases like sodium hydroxide and potassium hydroxide; and the buffer mixtures made with these acids, preferably using cations of weak bases, like NH₄⁺ and quaternary ammonium ions.

The surfactants may be non-ionic, cationic, anionic or amphoteric surfactants.

Components imparting the tin plating solution improved stability against decomposition may be reducing agents which prevent oxidation of tin(II) ions in the plating solution to tin(IV) ions. Such components may be aromatic hydroxy compounds, like hydroquinone.

In addition, the tin plating solution may contain complexing agents for tin ions, such as carboxylic acids or hydroxyl carboxylic acids. In particular the tin plating solutions having neutral pH value contain complexing agents.

In a preferred embodiment of the present invention method step (c) comprises depositing said tin layer at a tin layer thickness of at least 0.1 µm, more preferably at least 0.2 µm, even more preferably at least 1 µm and most preferably at least 2 µm. Furthermore preferably, said tin layer thickness is at most 10 µm, more preferably 5 µm and most preferably 4 µm. More preferably, tin is deposited at a thickness of from 0.1 µm to 10 µm, even more preferably from 0.2 µm to 5 µm, yet even more preferably from 1 µm to 5 µm and most preferably from 2 µm to 4 µm. A tin layer thickness of higher than 0.5 µm in addition allows the tin layer to act as a solder reservoir.

Preferably, the tin of the tin layer deposited by the methods of the present invention is pure tin. More preferably, a pure tin deposit is a deposit containing tin in an amount ranging from 98.0 to 99.99 wt.-% or higher, preferably from 99.0 to 99.99 wt.-% or higher, more preferably from 99.85 to 99.99 wt.-% or higher.

Preferably, the tin of the tin layer deposited by the methods of the present invention is no tin alloy, more preferably it is no tin-copper alloy, no tin-silver alloy and no tin-bismuth alloy. Thus, the tin of the tin layer deposited by the methods of the present invention preferably does substantially not contain any alloying elements or alloying metals, more preferably does substantially not contain copper, silver or bismuth as alloying metals. Substantially in this regard means that other elements or metals than tin are contained in the tin in an amount which is equal to or smaller than an amount occurring unintentionally as contaminants originating e.g. from components of the tin plating liquid. Preferably, the amount of other elements or metals than tin in the tin ranges from 2 to 0.01 wt.-% or lower, more preferably from 1 to 0.01 wt.-% or lower, more preferably from 0.15 to 0.01 wt.-% or lower.

It is known that tin-copper alloys and tin-bismuth alloys enhance tin whisker formation, in particular formation of pressure induced tin whiskers. Tin-bismuth alloys further increase whisker formation when having passed a reflow treatment for soldering. Tin-silver alloys also enhance formation of pressure induced tin whiskers. In addition, tin-silver alloys are difficult to deposit because of the different electrochemical potential of the two metals; the deposition process shows no stable performance over time and it is difficult to keep the ratio of tin to silver within the desired range in the deposit over time. In addition, a high amount of silver is required resulting in high costs. Also tin-bismuth alloys cause high costs because of the expensive bismuth.

According to the present invention the method comprises: (b) depositing a nickel/phosphorous alloy underlayer on at least one substrate surface prior to depositing said tin layer in above method step (c). By performing this further method step (b) a nickel/phosphorous alloy layer is formed which contributes to inhibition of pressure whisker formation. The nickel/phosphorous alloy layer further contributes to preventing substrate corrosion.

The nickel/phosphorous (NiP) alloy consists of nickel and one or more additional alloying elements. One of the additional alloying elements is preferably boron. Other alloying elements may be iron, or cobalt.

The nickel/phosphorous alloy may be any nickel alloy available by using a wet chemical metal plating method. The underlayer made of this alloy may preferably be formed using any wet chemical metal deposition method, including bringing the substrate surface into contact with a nickel/phosphorous alloy plating liquid so that nickel and phosphorous and optionally other metal ions or non-metal species, respectively, are discharged at the at least one substrate to become nickel or a nickel alloy, respectively, on the substrate. Any nickel/phosphorous alloy available by using a wet chemical metal plating method may be used. Such metal deposition may either be performed by using an electroplating method comprising letting an electric current flow between the substrate and a counter electrode while the substrate and the counter electrode are in contact with the plating liquid or by using an electroless (autocatalytic) plating method wherein the nickel and optionally other metal or non-metal species are discharged due to a reducing agent, namely hypophosphite ions, optionally additionally including borane compounds. If an electroplating method is used, this electroplating method preferably utilizes direct current (DC).

The plating liquid used to deposit the nickel/phosphorous alloy is preferably a plating solution containing one or more solvents, nickel ion species, one or more phosphorous alloying sources and optionally other alloying compounds, further ionic material imparting the plating solution enhanced electrical conductivity, if applicable a reducing agent capable of discharging the nickel ions to form nickel metal, if the plating liquid is an electroless plating liquid, namely a hypophosphite compound, further pH adjusting material, furthermore additional components, like surfactants to enhance wetting of the substrate surface with the plating solution and to increase solubility of components contained in the plating solution, as well as other material which may impart the plating solution improved stability against decomposition and/or which may impart the nickel/phosphorous alloy deposit improved properties, for example mechanical and/or electrical properties. Such plating solution is preferably aqueous and more preferably contains nickel ions, even more preferably formed from one or more nickel salts, like nickel sulfate, nickel chloride, nickel acetate, nickel methanesulfonate, nickel sulfamate, and the like.

If this plating solution is used to deposit the nickel/phosphorous alloy using an electroplating method, this plating solution additionally contains a phosphorous alloying source, such as phosphorous acid (H₃PO₃) and/or phosphonate (HPO₃²⁻) compounds, like an alkali phosphonate, sodium phosphonate for example. If this plating solution is used to deposit the nickel/phosphorous alloy using an electroless plating method, this plating solution may additionally contain a hypophosphite compound, like an alkali salt thereof, the sodium salt for example or hypophosphorous acid. This compound also serves as an alloying compound. If this plating solution is used to deposit the nickel/phosphorous alloy using an electroless plating method, this plating solution may additionally contain a complexing agent for nickel ions, and optionally for alloying metal ions, such as alkyl amines, ammonia, carboxylic acids like tartaric acid, hydroxyl carboxylic acids like citric acid, aminocarboxylic acids or their salts.

The ionic material imparting the plating solution enhanced electrical conductivity may be any inorganic or organic salt which readily dissociates in ionic species in the plating solution, preferably aqueous plating solution. This ionic material does not participate in nickel / phosphorous alloy deposition so that none of the constituents thereof is co-deposited together with nickel and phosphorous or the other elements alloying with nickel/phosphorous to form the nickel/phosphorous alloy layer. The inorganic or organic salt imparting the plating solution enhanced electrical conductivity may be an alkali salt, sodium, potassium, or other alkali salt for example, of an inorganic or organic anion, such as a sulfate, nitrate, phosphate, chloride, bromide, acetate, methanesulfonate, sulfamate and/or the like. Likewise such salt may be an earth alkaline salt, magnesium, calcium, or other earth alkaline salt for example, of any of these anions. More preferably, the ionic material imparting the plating solution enhanced electrical conductivity may be an inorganic or organic acid, i.e., a compound, such as a mineral acid like sulfuric acid, phosphoric acid, hydrochloric acid, hydrobromic acid and/or the like; acetic acid, methanesulfonic acid, sulfamic acid, and the like, which produces hydronium or other protonated solvent ions by dissociation in the plating solution.

The pH adjusting material may be any acid, base or buffer mixture, including a mineral acid such as sulfuric acid, phosphoric acid, hydrochloric acid, and/or hydrobromic acid; acetic acid, methanesulfonic acid, sulfamic acid; bases like sodium hydroxide or potassium hydroxide; and the buffer mixtures made with these acids, preferably using cations of weak bases, like NH₄⁺ and quaternary ammonium ions.

The surfactants may be non-ionic, cationic, anionic or amphoteric surfactants.

Other material which may impart the plating solution improved stability against decomposition may be lead ion species and organic compounds having triple bonds; compounds of Group VI elements like S, Se, Te; compounds containing oxygen like AsO₂⁻, IO₃⁻, MoO₄²⁻; heavy metal cations like Sn²⁺, Pb²⁺, Hg⁺, Sb³⁺; or unsaturated organic acids like maleic acid, itaconic acid or the like.

According to the present invention the method further comprises: (b1) depositing a nickel underlayer on said at least one surface of said substrate prior to depositing said tin layer in above method step (c). By performing this further method step (b1) a nickel underlayer is formed which further improves inhibition of pressure induced whisker formation. The nickel underlayer is a first underlayer being formed underneath the nickel/phosphorous alloy underlayer which is then a second underlayer, the nickel/phosphorous alloy is not deposited directly on at least one of the substrate surfaces but on the nickel underlayer. According to the present invention said nickel underlayer is deposited prior to depositing said nickel/phosphorous alloy underlayer in above method step (c). Not covered by the present invention, it may be deposited onto the nickel/phosphorous alloy underlayer so that it is placed between the nickel / phosphorous alloy underlayer and the tin layer. The combination of the nickel/phosphorous alloy layer with the nickel underlayer further contributes to preventing substrate corrosion.

The nickel layer consists of nickel or of nickel together with one or more metal alloying elements. It does not contain any one of the non-metal alloying elements like phosphorous or boron. One or more of the metal alloying elements may be iron, or cobalt.

The nickel underlayer may preferably be formed using a wet chemical metal deposition method, including bringing the substrate surface into contact with a nickel plating liquid so that nickel and optionally also other metal ions are discharged at the at least one substrate to become nickel or respective other metal which forms a nickel or nickel metal alloy layer, respectively, on the substrate. Such metal deposition may either be performed by using an electroplating method comprising letting an electric current flow between the substrate and a counter electrode while the substrate and the counter electrode are in contact with the plating liquid or by using an electroless (autocatalytic) plating method wherein the nickel and optionally other metal ions are discharged due to a reducing agent, like hydrazine compounds or formaldehyde. If an electroplating method is used, this electroplating method preferably utilizes direct current (DC).

The plating liquid used to deposit the nickel layer is preferably a plating solution containing one or more solvents, nickel ion species, optionally alloying metal ions, ionic material imparting the plating solution enhanced electrical conductivity, if applicable a reducing agent capable of discharging the nickel ions to form nickel metal, if the plating liquid is an electroless plating liquid; further pH adjusting material, furthermore additional components, like surfactants to enhance wetting of the substrate surface with the plating solution and to increase solubility of components contained in the plating solution, as well as other material which may impart the plating solution improved stability against decomposition and/or which may impart the nickel deposit improved properties, for example mechanical and/or electrical properties. Preferably, the main solvent is water.

For generating the nickel underlayer, a nickel plating solution is utilized. The nickel plating solution may be a nickel electroplating solution, like a Watts plating bath; which is an aqueous plating solution and typically contains nickel sulfate, nickel chloride, boric acid, saccharine and optionally further components known as stabilizers and being well-known to those skilled in the art. The nickel plating solution used to form the nickel underlayer may in an alternative be an electroless nickel plating bath which typically is an aqueous plating solution and which contains nickel sulfate, a hydrazine compound or formaldehyde as the reducing agent for nickel, and further components.

The nickel ion species, further ionic material imparting the nickel plating solution enhanced electrical conductivity, pH adjusting material, surfactants, material which may impart the nickel plating solution improved stability against decomposition, material which may impart the nickel deposit improved properties, and/or complexing agents contained in the nickel plating solution may be the same as described above for the nickel/phosphorous plating solution.

In a further preferred embodiment of the present invention said nickel/phosphorous alloy underlayer comprises phosphorous at a phosphorous content of not less than 0.1% by weight, preferably not less than 1 % by weight, more preferably not less than 5 % by weight, even more preferably not less than 8 % by weight. The phosphorous content may moreover be not higher than 17 % by weight, preferably not higher than 15 % by weight. More preferably, said nickel/phosphorous alloy underlayer comprises phosphorous at a phosphorous content of from 0.1 % by weight to 17 % by weight, preferably from 1 % by weight to 15 % by weight, more preferably from 5 % by weight to 15 % by weight, even more preferably from 8 % by weight to 15 % by weight, and yet even more preferably from 9 % by weight to 13 % by weight.

The nickel/phosphorous alloy plating liquid may additionally contain a boron alloying source so that a nickel/phosphorous/boron alloy is formed. In this case the boron alloying compound may be a boron compound, such as dimethylamineborane or sodium boranate.

In a further preferred embodiment of the present invention above method steps (b1), (b) comprise depositing a double layer comprising said first nickel underlayer and said second nickel / phosphorous alloy underlayer, wherein said double layer has a thickness of at least 0.01 µm, more preferably at least 0.05 µm and most preferably at least 0.08 µm. Furthermore preferably, said double layer thickness is at most 10 µm, more preferably at most 5 µm and most preferably at most 2 µm. More preferably, the double layer thickness is from 0.01 µm to 10 µm, even more preferably from 0.05 µm to 5 µm and most preferably from 0.08 µm to 2 µm. This nickel and/or nickel/phosphorous alloy thickness refers to the overall thickness of all nickel and nickel/phosphorous alloy underlayers, if more than one nickel or nickel alloy underlayer are deposited on at least one of the substrate surfaces. The double layer further contributes to preventing substrate corrosion.

Within the double layer, the first nickel underlayer preferably has a thickness of from 0.5 µm to 5 µm, more preferably of from 1 µm to 3 µm and even more preferably of from 1 µm to 2 µm. The second nickel/phosphorous alloy underlayer contained in the double layer has a thickness of from 0.01 µm to 2 µm, more preferably of from 0.05 µm to 1 µm and even more preferably of from 0.08 µm to 0.5 µm.

If the nickel/phosphorous alloy underlayer is the only present underlayer, the nickel / phosphorous alloy underlayer has a thickness of from 0.01 µm to 5 µm, more preferably of from 0.05 µm to 3 µm and even more preferably of from 0.08 µm to 2 µm.

According to the present invention the method further comprises: (d) depositing a silver or silver alloy top layer on said tin layer. By performing this further method step (d) a silver or silver alloy layer is formed which further improves inhibition of pressure induced whisker formation. In addition, depositing the tin layer and the silver or silver top layer separately from each other has a number of advantages over depositing a tin-silver alloy. Separate deposition of tin and silver or silver alloy layers is easier to perform, has a stable performance and is more reproducible. Further, a lower amount of silver is required thus reducing costs.

A silver alloy consists of silver and one or more alloying elements. The alloying elements may be gold, copper, palladium, platinum, ruthenium, iridium, and/or rhodium. Other alloying elements may be iron, cobalt, and/or copper.

Silver or a silver alloy is deposited using a wet chemical metal deposition method, comprising bringing the at least one substrate into contact with a silver or silver alloy plating liquid. If the wet chemical metal deposition method is an electroplating method, silver or a silver alloy is deposited by letting an electric current flow while the substrate is in contact with the plating liquid so that silver and optionally other metal ions are discharged at the substrate surface to become silver metal which forms a silver top layer or optionally, to become a silver alloy which forms a silver alloy top layer on the at least one substrate surface. In an alternative method variation an autocatalytic plating method may be employed wherein the silver ion species and optionally other metal ion species are discharged due to a reducing agent, like formic acid or formic acid derivatives. In a further alternative method variation an immersion plating method may be employed wherein the silver ion species and optionally other metal ion species are deposited by a displacement reaction with a metal present on the substrate surface. If an electroplating method is used, the electroplating method utilizes direct current (DC).

The silver or silver alloy plating liquid is preferably a silver or, respectively, silver alloy plating solution. This plating solution contains silver ion species and, optionally, alloying metal ion species, as well as a solvent. Furthermore preferably, the plating solution may include ionic material imparting the plating solution enhanced electrical conductivity if an electroplating method is used. Furthermore preferably, the plating solution may include pH adjusting material. Furthermore preferably, the plating solution may comprise further components, like surfactants to enhance wetting of the substrate surface with the plating solution and to increase solubility of components contained in the plating solution, and additional components imparting the plating solution improved stability against decomposition.

One or more solvents may be contained in the plating solution. The plating solution preferably contains water as one of the solvents. If water is contained in the plating solution as a major solvent component (at least 50 vol.-%) the silver or silver alloy plating solution is to be considered an aqueous plating solution. Additionally organic solvents may be contained in the plating solution, such as alcohols and/or ethers.

The silver plating solution may be a conventional silver electroplating solution, which is an aqueous plating solution. Silver electroplating solutions may be cyanide containing plating solutions or non-cyanide plating solutions. Cyanide containing silver plating solutions contain alkali silver cyanide compounds like potassium silver cyanide as silver ion species. Complexing agents may be cyanide salts like alkali cyanide compounds, such as potassium cyanide or sodium cyanide. The cyanide containing silver plating solutions may further contain additives like brightening agents and/or surfactants. Brightening agents may be selenium or sulfur containing compounds. The cyanide containing silver plating solutions are usually alkaline solutions which do not require additional pH adjusting agents.

Non-cyanide silver electroplating solutions typically contain silver nitrate as silver ion species and preferably an acid. Complexing agents may be succinimide, thiosulfate or derivatives thereof.

The silver plating solution may be a conventional silver plating solution used in an autocatalytic plating method. Preferably, the autocatalytic silver plating solution is an aqueous plating solution. The autocatalytic silver plating solution may contain silver nitrate as silver ion species; a reducing agent like glucose, tartaric acid, hydrazine and salts thereof; stabilizers and complexing agents which are well-known to those skilled in the art; and pH adjusting material.

The silver plating solution may in an alternative be an immersion silver plating solution which typically is an aqueous plating solution and which contains silver nitrate, optionally complexed with a silver complexing agent like cyanide salts, such as potassium cyanide; or thiosulfate. This plating solution may furthermore contain a reducing agent like formic acid. In addition, this plating solution may contain additional components, such as ionic material imparting the plating solution enhanced electrical conductivity, pH adjusting material, as well as other material which may impart the plating solution improved stability against decomposition.

The ionic material imparting the silver or silver alloy plating solution enhanced electrical conductivity may be any inorganic or organic salt which readily dissociates in ionic species in the plating solution. This ionic material does not participate in silver or silver alloy deposition so that none of the constituents thereof is co-deposited together with silver or the other metals alloying with silver to form the silver or silver alloy layer. The inorganic or organic salt imparting the plating solution enhanced electrical conductivity may be an alkali salt, sodium, potassium or other alkali salt for example, of an inorganic or organic anion, such as a carbonate, cyanide, sulfate, nitrate, acetate, methanesulfonate, sulfamate and/or the like. Likewise such salt may be an earth alkaline salt, magnesium, calcium, or other earth alkaline salt for example, of any of these anions. More preferably, the ionic material imparting the plating solution enhanced electrical conductivity may be an inorganic or organic acid, i.e., a compound, such as a mineral acid like sulfuric acid and/or the like; acetic acid, methanesulfonic acid, sulfamic acid and the like, which produces hydronium or other protonated solvent ions by dissociation in the plating solution.

The pH adjusting material preferably contained in the silver or silver alloy plating solution may be any acid, base or buffer mixture, including a mineral acid such as sulfuric acid; acetic acid, methanesulfonic acid, sulfamic acid; bases like sodium hydroxide, potassium hydroxide or ammonia; and the buffer mixtures made with these acids, preferably using cations of weak bases, like NH₄⁺ and quaternary ammonium ions.

The surfactants preferably contained in the silver or silver alloy plating solution may be non-ionic, cationic, anionic or amphoteric surfactants.

If a silver electroplating method is used, a current density of from 0.1 A/dm² to 5 A/dm², more preferably from 0.5 A/dm² to 2 A/dm², is applied to deposit silver or a silver alloy.

In a preferred embodiment of the present invention method step (d) comprises depositing said silver or silver alloy top layer at a silver or silver alloy thickness being at least 0.01 µm and more preferably being at least 0.05 µm. Furthermore preferably, said silver or silver alloy thickness is at most 0.5 µm, more preferably at most 0.2 µm. More preferably, silver or silver alloy thickness is from 0.01 µm to 0.5 µm and most preferably from 0.05 µm to 0.2 µm. For this to achieve a preferred silver or silver alloy deposition time, preferably an electrodeposition time, is used that ranges from 1 s to 2 min, more preferably from 10 s to 1 min.

In a further preferred embodiment, in addition to depositing the tin layer by using the pulse plating method, part of the tin layer (sublayer) may also be formed using a direct current (DC) plating method. Such additional tin sublayer deposited using DC current may, in a first variation, be formed prior to forming the tin layer produced with the pulse plating method or, in a second variation, after forming the tin layer produced with the pulse plating method. In a third variation a tin sublayer, produced with the DC method, may be formed prior to the tin sublayer deposited with the pulse plating method and a further tin sublayer, produced with the DC method, may be formed after the tin sublayer deposited with the pulse layer method. In a further preferred embodiment tin may also be deposited, additionally to electroplating tin using the pulse plating method, by using the DC method by first depositing tin at a low current density and thereafter at a high current density. This duplex sequence may be applied prior to tin pulse plating or after tin pulse plating or both, prior to and after, tin pulse plating.

The tin electroplating liquid used to electroplate tin using the DC method may have the same composition as the tin electroplating liquid which is used to electroplate tin using the pulse plating method. The conditions of electroplating tin using the DC method may be conventional, such as electroplating tin at a current density of at least 1 A/dm², more preferably at least 2 A/dm² and most preferably at least 5 A/dm². The current density may be at most 50 A/dm², more preferably at most 25 A/dm² and most preferably at most 15 A/dm². If a low current density is applied in the duplex sequence this current density is preferably from 1 A/dm² to 10 A/dm², more preferably from 2 A/dm² to 7.5 A/dm² and most preferably from 4 A/dm² to 6 A/dm². If a high current density is applied in the duplex sequence this current density is preferably from 10 A/dm² to 50 A/dm², more preferably from 12 A/dm² to 25 A/dm² and most preferably from 14 A/dm² to 16 A/dm². Each one of these preferred conditions apply with respect to the duplex sequence being applied prior to the tin pulse plating step or after the tin pulse plating step or both, prior to and after, the tin pulse plating step.

In one embodiment, the nickel/phosphorous alloy underlayer is formed prior to forming the tin layer, by depositing the nickel/phosphorous alloy underlayer directly on the at least one substrate surface. The tin layer is then formed on this nickel/phosphorous alloy underlayer being formed. If a silver or silver alloy top layer is deposited in addition to the tin layer, the silver or silver alloy top layer is formed on the tin layer. In another embodiment, the double layer comprising the nickel underlayer and the nickel/phosphorous alloy underlayer is formed prior to forming the tin layer, by depositing the nickel underlayer and the nickel/phosphorous alloy underlayer directly on the at least one substrate surface. The tin layer is then formed on this double layer being formed. If a silver or silver alloy top layer is deposited in addition to the tin layer, the silver or silver alloy top layer is formed on the tin layer.

According to the present invention said pulse plating method is a unipolar pulse plating method, said unipolar pulse plating method comprising successive pulse periods each comprising a cathodic pulse section (plating section) and a zero current pulse section (non-plating section). Preferably, the successive pulse periods are identical and follow each other. Tin is deposited during the cathodic pulse section. During the zero current pulse section, tin is not deposited on the nickel/phosphorous alloy underlayer which is deposited on at least one substrate surface.

According to the present invention said cathodic pulse (section) has a cathodic pulse duration of at least 0.1 s, more preferably at least 0.2 s and most preferably at least 0.5 s. Furthermore preferably, said cathodic pulse duration is at most 10 s, more preferably at most 5 s and most preferably at most 1 s. More preferably, the cathodic pulse duration is from 0.1 s to 10 s, even more preferably from 0.2 s to 5 s and most preferably from 0.5 s to 1 s.

According to the present invention said zero current pulse (section) has a zero current pulse duration of at least 0.1 s, more preferably at least 0.2 s and most preferably at least 0.5 s.

Furthermore preferably, said zero current pulse duration is at most 10 s, more preferably at most 5 s and most preferably at most 1 s. More preferably, the zero current pulse duration is from 0.1 s to 10 s, even more preferably from 0.2 s to 5 s and most preferably from 0.5 s to 1 s.

In an even more preferred embodiment of the present invention the frequency of said unipolar pulse plating method is at least 0.05 s⁻¹, more preferably at least 0.1 s⁻¹ and most preferably at least 0.5 s⁻¹. Furthermore preferably, the frequency of said unipolar pulse plating method is at most 5 s⁻¹, more preferably at most 2.5 s⁻¹ and most preferably at most 1 s⁻¹. More preferably, said frequency is from 0.05 s⁻¹ to 5 s⁻¹, even more preferably from 0.1 s⁻¹ to 2.5 s⁻¹ and most preferably from 0.5 s⁻¹ to 1 s⁻¹.

In an even more preferred embodiment of the present invention said cathodic pulse (section) has a cathodic pulse peak current density of at least 1 A/dm², more preferably at least 5 A/dm², even more preferably at least 10 A/dm² and most preferably at least 8 A/dm². Furthermore preferably, said cathodic pulse has a cathodic pulse peak current density of at most 60 A/dm², more preferably at most 35 A/dm² and most preferably at most 20 A/dm². More preferably, said cathodic pulse peak current density is from 1 A/dm² to 60 A/dm², even more preferably from 5 A/dm² to 35 A/dm², yet even more preferably from 10 A/dm² to 35 A/dm² and most preferably from 8 A/dm² to 20 A/dm². These cathodic pulse peak current densities are suitable for depositing the tin layer by pulse plating, particularly for rack application.

In an even more preferred embodiment of the present invention said cathodic pulse (section) has a cathodic pulse peak current density for reel-to-reel/strip-to-strip application of at least 10 A/dm², more preferably at least 15 A/dm² and most preferably at least 25 A/dm². Furthermore preferably, said cathodic pulse has a cathodic pulse peak current density of at most 60 A/dm², more preferably at most 45 A/dm², even more preferably at most 35 A/dm² and most preferably at most 25 A/dm². More preferably, said cathodic pulse has a cathodic pulse peak current density for reel-to-reel/strip-to-strip application of from 10 A/dm² to 60 A/dm², even more preferably from 15 A/dm² to 45 A/dm², yet even more preferably from 10 A/dm² to 35 A/dm² and most preferably of 25 A/dm².

In an even more preferred embodiment of the present invention the ratio of the cathodic pulse duration to the zero current pulse duration is at least 0.5, more preferably at least 0.75 and most preferably at least 0.9. Furthermore preferably, this ratio is at most 2, more preferably at most 1.5 and most preferably at most 1.1. More preferably this ratio is set from 0.5 to 2, even more preferably from 0.75 to 1.5 and most preferably from 0.9 to 1.1. Still even more preferably this ratio is 1.0.

The method of depositing a tin layer on a metal substrate according to the present invention is preferably for suppressing formation of pressure induced tin whiskers to a lower level, more preferably for preventing formation of pressure induced tin whiskers, even more preferably for forming a tin layer being free of pressure induced whiskers.

Thus, preferably, in the tin layer deposited by the method of the present invention the formation of pressure induced tin whiskers is suppressed to a lower level, more preferably formation of pressure induced tin whiskers is prevented, even more preferably the tin layer deposited by the method of the present invention is free of pressure induced whiskers.

Preferably, pressure induced tin whiskers being suppressed to a lower level, or pressure induced tin whiskers being prevented, or being free of pressure induced whiskers of the tin layer deposited by the method of the present invention are/is determined, e.g. tested, by subjecting said tin layer to a mechanical force at a predetermined pressure for a predetermined period of time. Applying a mechanical force to the tin layer induces formation of pressure induced whiskers, but does not induce formation of other kind of whiskers like corrosion induced whiskers, whiskers induced by formation of intermetallic compounds or whiskers induced by a thermal mismatch. Applying means for inducing other kinds of whiskers is of no significance regarding formation of pressure induced whiskers. Thus, the tendency of a tin layer to form pressure induced whiskers can be tested by applying a mechanical force and it can be distinguished from tendencies of the same tin layer to form other kinds of whiskers.

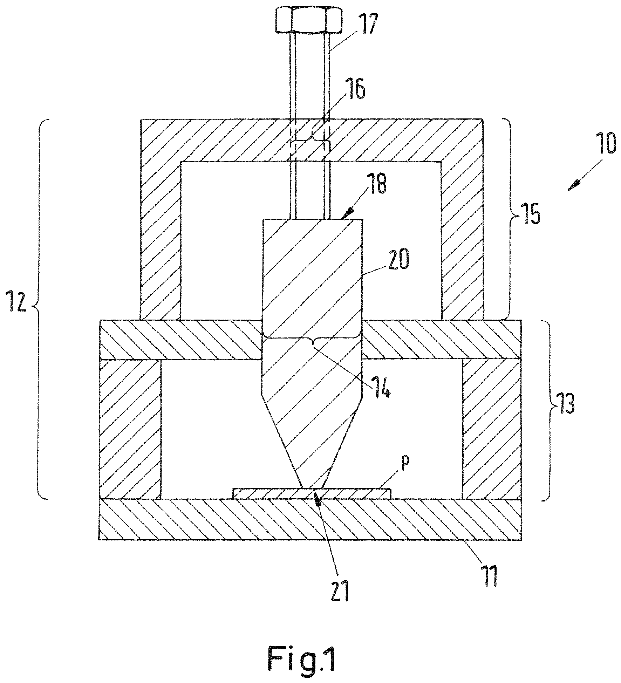

More preferred embodiments of this method comprise any one or several of the further improvements which are described herein above. The tin layer is subjected preferably directly, i.e., without any post-treatment like a heat treatment, to the mechanical force. Preferably, if step (d) is performed after performing step (c), i.e. a silver or silver alloy top layer is deposited on said tin layer, the tin layer is subjected to the mechanical force after depositing the silver or silver alloy top layer, more preferably without any post-treatment like a heat treatment. The mechanical force may be applied to the tin layer by subjecting the metal substrate to the mechanical force, by pressing a tool to the tin layer for example. In practice, this mechanical force may be applied to the tin layer by inserting male and female terminals of a contact element pair which are plated with the nickel / phosphorous alloy underlayer and the tin layer into each other. Preferably, the tool to be pressed onto the tin layer is a screw type whisker jig as described below and by Fig. 1.

The predetermined pressure may be at least 0.001 Nm, more preferably at least 0.01 Nm, even more preferably at least 0.05 Nm and most preferably at least 0.1 Nm. The predetermined pressure may be at most 100 Nm, more preferably at most 10 Nm, even more preferably at most 5 Nm and most preferably at most 1 Nm. The predetermined pressure may range from 0.001 Nm to 100 Nm, more preferably from 0.01 Nm to 10 Nm, even more preferably from 0.05 Nm to 5 Nm and most preferably from 0.1 Nm to 1 Nm. The predetermined period of time may be at least 1 min, more preferably at least 1 hour, even more preferably at least 1 day and most preferably at least 5 days. The predetermined period of time may be at most the life time of the plated substrate, i.e. a plated contact element; more preferably at most 1 year, even more preferably at most 1 month, yet more preferably at most 2 weeks and most preferably at most 10 days. The predetermined period of time may range from 1 min to the end of the life time of the plated substrate, more preferably from 1 min to 1 year, even more preferably from 1 hour to 1 month, yet more preferably from 1 day to 2 weeks and most preferably from 5 days to 10 days.

Preferably, finally, after subjecting said tin layer to a mechanical force, the number and/or size of pressure induced tin whiskers obtained are measured. Measuring number and/or size of the whiskers may be performed by using a microscope like a SEM (scanning electron microscope). Measuring the size of the whiskers may be performed by evaluating or analyzing the whiskers as described below and within the Examples.

It is therein to be understood that determining the feature "being free of pressure induced whiskers of the tin layer" described by the parameters pressure and time will stand for the particular property of the deposited tin layer according to the present invention and can be tested as described above. With other words "being free of pressure induced whiskers of the tin layer" means that the deposited tin layer according to the present invention will be free of pressure induced whiskers of the tin layer within the parameters described e.g. by the method below.

The method of the invention is preferably performed in an apparatus wherein the substrate to be plated is immersed into the plating liquids, one after the other, these plating liquids being accommodated in respective containers and the substrate being transferred from one container to the next while residing in each one for the time required to deposit the respective metal layer on the at least one surface thereof.

For this purpose the plating apparatus comprises a couple of containers for these electroplating liquids as well as means for holding the substrate, wherein said means is capable of transferring the substrate from one container to the other and immersing the substrate into the respective plating liquid. The means for holding the substrate may be any holder like a frame which is in turn held by a flight bar for example. Alternatively, the holding means may be rollers transporting the substrate through a conveyorized apparatus wherein the substrate is contacted with the plating liquids consecutively.

Furthermore, the apparatus comprises means for bringing each one of the substrate and at least one counter electrode (anode) into contact with the electroplating liquid, if the metal to be deposited is electroplated on the at least one surface of the substrate. This is by all means the case for the tin plating operation wherein the pulse plating method is applied. In case of an electroless (autocatalytic) or immersion (displacement) plating operation no counter electrode system is required. The at least one counter electrode is preferably located in the vicinity of the substrate and is, together with the substrate, brought into contact with the electroplating liquid, to cause an electrical current flow between the substrate and the at least one counter electrode. In a horizontal conveyorized system a plurality of counter electrodes may be placed in succession along the conveyor path for the substrate, either on one side of the conveyor path or on both sides of the conveyor path.

The apparatus furthermore comprises a means for electrically polarizing the substrate to effect metal deposition onto the at least one substrate surface if the method involves an electroplating action. This polarizing means serves for feeding electrical energy to the substrate. For this purpose it may be a current/voltage source/supply, such as a rectifier. The polarizing means is electrically connected to the substrate and the at least one counter electrode. For the deposition of the tin layer, the polarizing means is furthermore designed to feed pulse current to the at least one substrate surface. For this purpose the polarizing means is electrically connected to the at least one substrate surface and may be equipped with a control means which provides for the generation of the pulse trains. Such control means may be an electrical circuit arrangement which may be driven by a microcontroller which in turn may be programmed by a computer.

The following figures and examples explain the invention in more detail. These figures and examples exclusively serve the understanding and do not limit the scope of the invention as claimed.
- Fig. 1: shows a screw type whisker jig in a sectional side view;
- Fig. 2: shows the border area of an indentation in a tin main layer created with the indenter of the screw type whisker jig shown in Fig. 1 as an SEM photograph;
- Fig. 3: shows graphs of the shorting length of whiskers generated on various tin layers.
- Fig. 4: shows graphs of the shorting length of whiskers generated on further tin layers.

Pressure induced whisker formation was studied at various layer combinations on a substrate, wherein these layers each comprised a (pure) tin layer. In each case a copper plate was used as the substrate. This plate was provided with the various layer combinations by depositing the individual layers on the plate and onto each other. For the layers being deposited the plate was first cleaned and thereafter plated with tin and optionally with further metal coatings. The tin coatings were about 3.0 to 3.5 µm thick.

Unless otherwise indicated, the plates being provided with the layer combinations were heat treated for 1 h at 150 °C in air within 24 hours after the layers had been formed, in order to simulate industrial manufacturing processes as currently used. After cooling the samples to room temperature, they were individually tested for whisker formation in a screw type whisker jig having an indenter provided with a flat circular tip.

Fig. 1 shows a screw type whisker jig 10 typically being used for examining pressure induced whisker formation. This jig includes a vertically slidable indenter 20 having a flat indenter tip 21 which has a circular area with a diameter of 3 mm. Preferably, the indenter 20 is bar-shaped or rod-shaped. The jig comprises a base plate 11 and a holding structure 12 holding the indenter. The base plate is formed to accommodate a plate sample P as a metal substrate having a tin layer Sn being deposited thereon. The holding structure comprises a guiding element 13 which is formed to slidably guide the indenter in a lead-through opening 14 thereof. Further, the holding structure also comprises a retaining bracket 15 elevating on the guiding element and having a threaded hole 16 to accommodate a threaded bolt 17 which presses onto the front face 18 of the indenter.

The plate sample P was mounted to the jig 10 by placing it on the base plate 11 just below the indenter tip 21. Then the indenter 20 with its indenter tip was pressed onto the surface of the base plate by screwing the threaded bolt 17 downwards with a torque wrench so that a torque of 0.3 Nm was finally applied to the threaded bolt. This pressure was maintained for a predetermined period of time, 1 week for example.

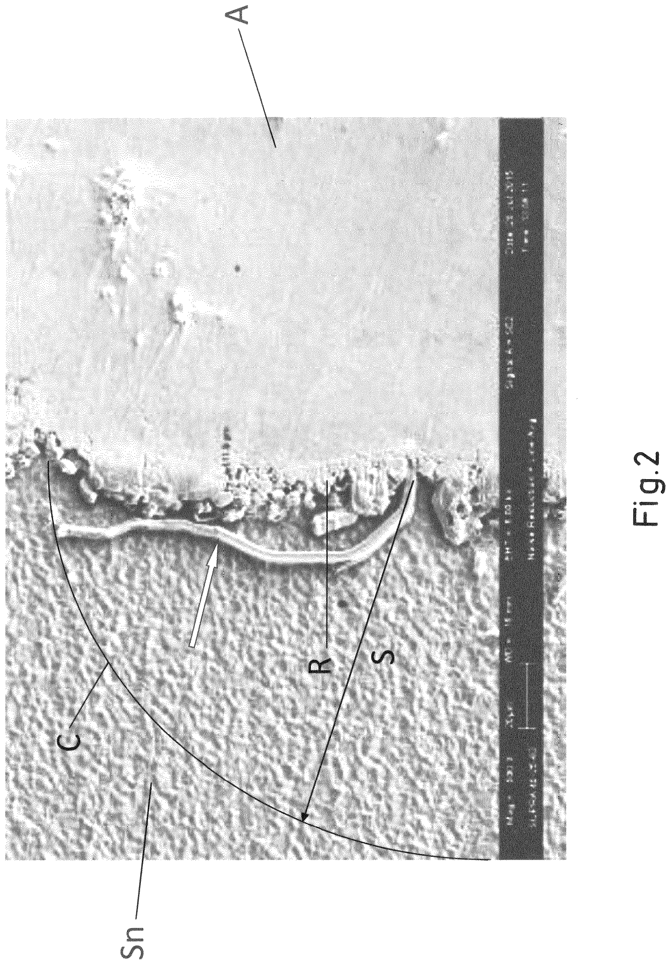

The pressure thus created on the samples lead to whisker formation at the border of the indentation A created with the indenter tip. A typical example of such whiskers being formed is shown in Fig. 2 as an SEM photograph. The sample used for this example had a tin layer Sn only. This tin layer was produced by electroplating using a direct current (DC) plating method. Accordingly, this sample was not prepared according to the invention. Fig. 2 shows a smooth area at the indentation A where the indenter tip has exerted its pressure during the testing period (predetermined period of time), so that the layer was flattened. Outside this area the topology of the slightly rough surface of the tin layer is visible as plated. At the border of the smooth area the material is seen to having been squeezed out so that a ridge R was generated. At this ridge a large pressure induced whisker has been produced (see bold arrow) which has first grown approximately radially from the indentation and then after a short travel has propagated to a direction approximately parallel to the ridge.

In order to check for the trend (tendency) of producing pressure induced whiskers the samples which were previously loaded with the indenter for 1 week were then examined using SEM and the whiskers being formed were evaluated. For this analysis the largest extension each one of the whiskers has attained, measured from its origin at the ridge, was determined individually. This length could clearly be smaller than the overall length of the whisker as it may, due to bending, remain in the vicinity of its origin. In order to determine this extension a semicircle C was drawn about the whisker's origin while touching the farthest extension of the whisker within this semicircle. The radius of this semicircle was taken as the shorting length S of this individual whisker. Those five whiskers were analyzed in this way that had the largest extensions and a mean value Sₘₑₐₙ was determined for the shorting length.

### Comparative Examples 1, 2:

Test samples for comparative examples were prepared by pretreating copper plates in a conventional manner, i.e., by cathodically cleaning the plates in an alkaline cleaner, then etching the plates in an acidic cleaner and finally activating them in diluted sulfuric acid.

The cleaned plates were then provided with a nickel deposit and with a tin deposit plated onto the nickel deposit, as is shown in Table 1. For this purpose the copper plates were plated under the conditions as shown in Table 2. The plating baths and conditions used for depositing the individual layers are indicated hereinafter.

Nickel Electroplating (Underlayer 1 or first underlayer):
Pure nickel was applied to the cleaned copper plate using a conventional Watts nickel electroplating bath which was operated at standard conditions. Electroplating was performed using DC current. Thickness of the nickel deposit obtained was as is indicated in Table 2.

Tin Pulse Electroplating (Tin Layer):
Tin was electroplated using a tin electroplating bath made up on a tin methanesulfonate / methanesulfonic acid basis. The tin layer was obtained by applying pulse current to the plate.

The pulse current was a unipolar pulse current having a pulse train with successive identical pulse periods which comprised a cathodic current pulse followed by a zero current pulse and without any other pulse sections in the pulse periods. The pulses were rectangular with time. The pulse durations and cathodic peak current densities of the cathodic pulse current section were as is indicated in Table 2. Thickness of the tin deposit achieved was as is indicated in Table 2.

After plating the nickel and tin layers, the coated plates were heat treated for 1 h at 150 °C. Thereafter the plates were clamped into the screw type whisker jig and loaded with 0.3 Nm for 1 week at room temperature.

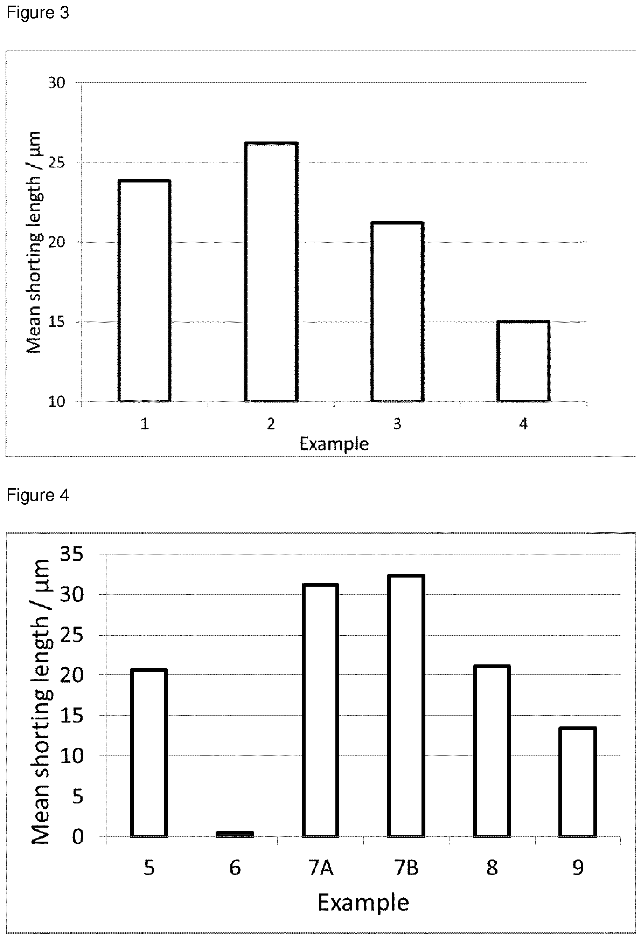

Formation of whiskers was subsequently determined by examining the plate surfaces in an SEM by evaluating the five largest whiskers and by measuring their shorting lengths S. A mean value was calculated from the five largest whiskers, this mean value giving the mean shorting length Sₘₑₐₙ. The results of this evaluation are shown in Fig. 3, indicating the shorting length mean Sₘₑₐₙ for all five whiskers of each sample. The result of the Comparative Examples is indicated as '1' and '2' in Fig. 3. The result is also summarized in Table 1.

### Example. 4 of the Invention:

Test samples according to the invention were prepared in the same manner as the specimen used in the comparative examples 1 and 2. The cleaned plates were then provided with various metal deposits as shown in Table 1. For this purpose the copper plates were again plated under the conditions as shown in Table 2. The plating baths used for preparing the nickel and tin deposits were those described herein before with reference to the comparative examples 1 and 2. The plating baths used to prepare nickel/phosphorous alloy and silver top layers and the conditions used for preparing these deposits are indicated hereinafter.

Nickel/Phosphorous Alloy Electroplating (Underlayer 2):
A nickel/phosphorous alloy was electroplated as a second underlayer (underlayer 2) on the nickel deposit (first underlayer) which was previously applied onto the copper plate (Examples 3 (comparative), 4 (inventive)). The nickel/phosphorous electroplating bath was a conventional plating bath including sodium phosphonate (Na₂HPO₃) as a phosphorous source to include phosphorous into the deposit. The nickel ion concentration in the bath was 120 g/l, pH of the bath was 1.5 and temperature was 65 °C. Electroplating was performed using DC current.

Thickness of the nickel deposit was as is indicated in Table 2.

Silver Top layer (Top layer):
In the case of Example 4 (inventive example) a silver top layer was deposited onto the tin layer using an Argalux^{®} NC mod electroplating bath of Atotech Deutschland GmbH. This bath was made up on a non-cyanide basis. The pH was 8.8 and the temperature was 20 °C.

Electroplating was performed using DC current. Thickness of the silver deposit was as is indicated in Table 2.

After plating the tin layer and the silver top layer (if a silver top layer was deposited), the coated plates were heat treated for 1 h at 150 °C. Thereafter the plates were clamped into the screw type whisker jig and loaded with 0.3 Nm for 1 week at room temperature.

Formation of whiskers was subsequently determined by examining the plate surfaces in an SEM. The shorting lengths S of individual pressure induced whiskers were examined for each specimen and the mean shorting length Sₘₑₐₙ was calculated as described in Comparative Examples 1, 2 and 3. The results of this evaluation are shown in Fig. 3, wherein the result of the Example 4 of the Invention are indicated as '4'. The results are also summarized in Table 1.

These values were compared to the respective ones obtained in the Comparative Examples 1, 2. It turned out that the mean shorting lengths Sₘₑₐₙ of the Examples 3 and according to the Invention 4 were significantly smaller than Sₘₑₐₙ of the samples of the Comparative Examples 1, 2. This means that electrodeposition of tin using a pulse plating method together with plating the copper plates first with the nickel/phosphorous alloy prior to plating with the tin layer clearly inhibit pressure induced whisker formation. While electroplating with an underlayer of nickel under the tin layer only (Comparative Examples 1, 2) leads to pressure induced whiskers having a mean shorting length Sₘₑₐₙ of between 20 µm and 30 µm, additional inclusion of the nickel / phosphorous alloy underlayer yields a considerable decrease of the tendency of whisker formation to well below 20 µm and even to about 10 µm. Additional application of a silver top layer on top of the tin layer tends to further optimize pressure induced whisker prevention to yield shorting lengths of below 10 µm.

### Comparative Example 5:

A copper plate was pretreated as described herein before and plated with the respective metal deposits as given in Table 3 under the condition as described before. The copper plate was plated under the conditions as shown in Table 4. Thickness of the nickel deposit obtained was as is indicated in Table 4. Pulse durations and cathodic peak current density of the cathodic pulse current section for tin electroplating were as is also indicated in Table 4. The compositions of the plating liquids and plating conditions were as is described for Examples 1, 2, 3, 4 herein above.

After the deposits were prepared, the sample was clamped into the screw type whisker jig and loaded with 0.3 Nm for 1 week at room temperature without any heat treating.

Formation of whiskers was subsequently determined as described in Comparative Examples 1 and 2. The result of this evaluation is shown in Fig. 4, indicating the result as '5' therein. The result is also shown in Table 3.

### Example of the Invention 6:

A test sample according to the invention was prepared in the same manner as the specimen used in Comparative Example 5. The cleaned copper plate was provided with various metal deposits as shown in Table 3. For this purpose the copper plate was again plated under the conditions as shown in Table 4. Thickness of the nickel, nickel/phosphorous alloy, and silver deposits obtained was as is indicated in Table 4. Pulse durations and cathodic peak current density of the cathodic pulse current section for tin electroplating were as is also indicated in Table 4. The plating baths used for preparing the nickel, nickel/phosphorous alloy, tin, and silver deposits as well as the conditions used for preparing these deposits were as is described for Examples 1, 2, 3, 4 herein above.

After the deposits were prepared, the sample was clamped into the screw type whisker jig and loaded with 0.3 Nm for 1 week at room temperature without any heat treating.

Formation of whiskers was subsequently determined as described in Comparative Examples 1 and 2. The result of this evaluation is shown in Fig. 4, indicating the result as '6' therein. The result is also shown in Table 3.

No whisker at all has been formed in the Example of the Invention whereas whiskers have been formed having an Sₘₑₐₙ of about 20 µm in the case of the Comparative Example 5.

### Comparative Example 7A, 7B:

Two specimen of a copper plate were pretreated as described herein before and plated with the respective metal deposits as given in Table 3 under the conditions as described before. The copper plates were plated under the conditions as shown in Table 4. Thickness of the nickel deposit obtained was as is indicated in Table 4. Pulse durations and cathodic peak current density of the cathodic pulse current section were as is also indicated in Table 4. The compositions of the plating liquids and plating conditions were as is described for Examples 1, 2, 3, 4 herein above.

After plating the nickel and tin layers, the coated specimen were heat treated for 1 h at 150 °C. Thereafter, the plates were clamped into the screw type whisker jig and loaded with 0.3 Nm for 1 week at room temperature. Formation of whiskers was subsequently determined as described in Comparative Examples 1 and 2. The results of this evaluation are shown in Fig. 4, indicating the results as '7A, 7B' therein. The result is as well shown in Table 3.

### Example of the Invention 9:

Two specimen of copper plates each were pretreated in the same manner as the specimen used in Comparative Example 7A, 7B.

The cleaned plates were then provided with various metal deposits as shown in Table 3. For this purpose the copper plates were again plated under the conditions as shown in Table 4. Thickness of the nickel, nickel/phosphorous alloy, and silver deposits obtained was as is indicated in Table 4. Pulse durations and cathodic peak current densities of the cathodic pulse current section were as is also indicated in Table 4. The plating baths used for preparing the nickel, nickel/phosphorous alloy, tin, and silver deposits as well as the conditions used for preparing these deposits were as is described for Examples 1, 2, 3, 4 herein above.

After the deposits were prepared, the coated plates were heat treated for 1 h at 150 °C.

Thereafter, the plates were clamped into the screw type whisker jig and loaded with 0.3 Nm for 1 week at room temperature. Formation of whiskers was subsequently determined as described in Comparative Examples 1 and 2. The results of this evaluation are shown in Fig. 4, indicating the results as '8 (comparative), 9' (inventive) therein. The results are as well shown in Table 3.

It turns out that when comparing Sₘₑₐₙ of Comparative Examples 7A, 7B to Sₘₑₐₙ of the Examples 8 and of the Invention 9 (with heat treating: Sₘₑₐₙ above 30 µm as compared to about 20 µm and below), considerable improvement in avoiding pressure induced whisker formation can be achieved by including a nickel/phosphorous alloy underlayer and also by additionally electroplating the tin layer with a silver top layer.

### Comparative Example 10:

Several specimen of copper plates were pretreated as described herein before and plated with the respective metal deposits in the same manner as the samples of the Example 7A, 7B (Comparative Example: nickel deposit, tin deposit). The copper plates were plated under the conditions as shown in Table 4 for Example 7A, 7B. Thickness of the nickel deposit obtained was as is indicated in Table 4. Pulse durations and cathodic peak current densities of the cathodic pulse current section for tin electroplating were as is also indicated in Table 4. The compositions of the plating liquids and plating conditions were as is described for Examples 1, 2, 3, 4 herein above.

A first part of the specimen were then heat treated for 1 hour at 150 °C and thereafter stored in an atmosphere of 87 % relative humidity at 55 °C isothermally for 4000 hours. Due to this storage a number of corrosion induced whiskers were formed. These whiskers were evaluated similarly as is described in Examples 1 and 2.

A second part of these specimen comprising the metal deposits were additionally treated in an aqueous liquid containing an alkyl phosphonic acid and a non-ionic surfactant (post-treatment). After this treatment, these specimen were also heat treated for 1 hour at 150 °C and thereafter stored under the conditions of 87 % relative humidity at 55 °C isothermally for 4000 hours. It could be shown that these post-treated specimen exhibited corrosion induced whiskers at a much lower amount and with smaller shorting lengths S than those of the first part of specimen.

It therefore turns out that treatment of the tin layer with the aqueous liquid containing the alkyl phosphonic acid and the non-ionic surfactant prevents corrosion induced whiskers.

A third part of these specimen comprising the metal deposits were likewise additionally treated with the aqueous liquid containing the alkyl phosphonic acid and non-ionic surfactant and, after heat treating them for 1 hour at 150 °C, were clamped into the screw type whisker jig and loaded with 0.3 Nm for 1 week at room temperature.

In this case a large number of pressure induced whiskers were formed. The amount and size of pressure induced whiskers formed was the same as is shown in Fig. 4 for Comparative Example 7A, 7B. In fact, the amount and size of pressure induced whiskers was much larger than that of the corrosion induced whiskers formed in the case of the second part of specimen.

It therefore turns out that the formation of pressure induced whiskers cannot be prevented by post-treating the samples using the aqueous liquid containing the phosphonic acid and surfactant, though this liquid is suitable to prevent corrosion induced whisker formation.

### Comparative Example 11:

Several specimen of copper plates were pretreated as described herein before and plated with tin deposits only under the conditions described in Comparative Example 1. Pulse durations and cathodic peak current densities of the cathodic pulse current section for tin electroplating were as is also indicated in Table 2 for Example 1. The composition of the tin plating liquid was as is described for Example 1 herein above.

A first part of the specimen were then stored in an atmosphere of 60 % relative humidity at 30 °C isothermally for 4000 hours. Due to this storage a number of whiskers induced by formation of an intermetallic compound between the copper substrate and the tin layer were formed. These whiskers were evaluated similarly as is described herein for Examples 1 and 2.

A second part of these specimen comprising the tin deposit were firstly heat treated for 1 hour at 150 °C and thereafter stored in an atmosphere of 60 % relative humidity at 30 °C isothermally for 4000 hours. It could be shown that these heat-treated specimen exhibited whiskers induced by formation of an intermetallic compound at a much lower amount and with smaller shorting lengths S than those of the first part of specimen.

It therefore turns out that treatment of the tin layer with heat prevents whiskers induced by formation of an intermetallic compound.

A third part of these specimen comprising the tin deposit were likewise additionally heat treated for 1 hour at 150 °C, and afterwards were clamped into the screw type whisker jig and loaded with 0.3 Nm for 1 week at room temperature.

In this case a large number of pressure induced whiskers were formed. The amount and size of pressure induced whiskers formed was much larger than that of the whiskers induced by formation of an intermetallic compound formed in the case of the second pre-treated part of specimen.

It therefore turns out that the formation of pressure induced whiskers cannot be prevented by heat treating the samples, although the heat treatment is suitable to prevent whiskers induced by formation of an intermetallic compound.

**Table 1:**

| Ex. | Underlayer 1 | Underlayer 2 | Tin Layer | Top layer | Sₘₑₐₙ / [µm] |
|---|---|---|---|---|---|
| 1 | Ni | ./. | Sn | ./. | 23.9 |
| 2 | Ni | ./. | Sn | ./. | 26.2 |
| 3 | Ni | NiP (≈ 12 wt.-% P) | Sn | ./. | 21.2 |
| 4 | Ni | NiP (≈ 12 wt.-% P) | Sn | Ag | 15.0 |

**Table 2:**

| | Underlayer 1 | Underlayer 2 | Tin Layer | | | Top layer |
|---|---|---|---|---|---|---|
| Ex. | Ni Thickness [µm] | NiP Thickness [µm] | Pulse durations (cath./zero curr.) | Cath. Peak Current Density | Sn Thickness [µm] | Ag Thickness [µm] |
| 1 | 1.5 µm | ./. | 1 s / 1 s | 30 A/dm² | 3 µm | ./. |
| 2 | 1.5 µm | ./. | 0.5 s / 0.5 s | 30 A/dm² | 3 µm | ./. |
| 3 | 1.4 µm | 0.1 µm | 1 s / 1 s | 30 A/dm² | 3 µm | ./. |
| 4 | 1.4 µm | 0.1 µm | 1 s / 1 s | 30 A/dm² | 3 µm | ≈ 0.1 µm |

**Table 3:**

| Ex. | Underlayer 1 | Underlayer 2 | Tin Layer | Top layer | Sₘₑₐₙ / [µm] |
|---|---|---|---|---|---|
| 5 | Ni | ./. | Sn | ./. | 20.6 |
| 6 | Ni | NiP (≈ 12 wt.-% P) | Sn | Ag | 0 |
| 7A | Ni | ./. | Sn | ./. | 31.2 |
| 7B | Ni | ./. | Sn | ./. | 32.3 |
| 8 | Ni | NiP (≈ 12 wt.-% P) | Sn | ./. | 21.1 |
| 9 | Ni | NiP (≈ 12 wt.-% P) | Sn | Ag | 13.4 |

**Table 4:**

| | Underlayer 1 | Underlayer 2 | Tin Layer | | | Top layer |
|---|---|---|---|---|---|---|
| Ex. | Ni Thickness | NiP Thickness | Pulse durations (cath./zero curr.) | Cath. Peak Current Density | Sn Thickness | Ag Thickness [µm] |
| 5 | 1.5 µm | ./. | 1 s / 1 s | 30 A/dm² | 3 µm | ./. |
| 6 | 1.5 µm | 0.1 µm | 1 s / 1 s | 30 A/dm² | 3 µm | 0.1 µm |
| 7A | 1.5 µm | ./. | 1 s / 1 s | 30 A/dm² | 3 µm | ./. |
| 7B | 1.5 µm | ./. | 1 s / 1 s | 30 A/dm² | 3 µm | ./. |
| 8 | 1.5 µm | 0.1 µm | 1 s / 1 s | 30 A/dm² | 3 µm | ./. |
| 9 | 1.5 µm | 0.1 µm | 1 s / 1 s | 30 A/dm² | 3 µm | 0.1 µm |

| | | | | | | |
|---|---|---|---|---|---|---|
| "Ex." means Example, "./." means not deposited. | | | | | | |

### Comparative Example 12 and 13:

Two specimen of copper plates each were pretreated in the same manner as the specimen used in Comparative Example 7A, 7B.

The pretreated plates were then provided with various metal deposits as shown in Table 5. For this purpose the copper plates were again plated under the conditions as shown in Table 6. In Example 12, the tin layer was deposited by unipolar pulse plating. In comparative Example 13, the tin layer was deposited by using direct current. Thickness of the nickel, nickel/phosphorous alloy and tin deposits obtained was as is indicated in Table 6. Pulse durations, cathodic peak current densities of the cathodic pulse current section and current densities of direct current were as is also indicated in Table 6. The average current density of Example 12 was 15 A/dm² and thus corresponded to the direct current density of Example 13. The plating baths used for preparing the nickel, nickel/phosphorous alloy, and tin deposits as well as the conditions used for preparing these deposits were as is described for Examples 1, 2, 3, 4 herein above.

After plating the tin layers, the coated plates were heat treated for 1 h at 150 °C. Thereafter, the plates were clamped into the screw type whisker jig and loaded with 0.3 Nm for 1 week at room temperature. Formation of whiskers was subsequently evaluated as described in Comparative Examples 1 and 2. The results are shown in Table 5.

It turns out that when comparing Sₘₑₐₙ of comparative Example13 with Sₘₑₐₙ of the Example 12, considerable improvement in avoiding pressure induced whisker formation can be achieved by performing tin deposition by pulse plating instead of using direct current.

### Example of the Invention 14 vs. Comparative Example 15:

Two specimen of copper plates each were pretreated in the same manner as the specimen used in Comparative Example 7A, 7B.

The pretreated plates were then provided with various metal deposits as shown in Table 5. For this purpose the copper plates were again plated under the conditions as shown in Table 6. In Example 14 according to the invention, the tin layer was deposited by unipolar pulse plating. In comparative Example 15, the tin layer was deposited by using direct current. Thickness of the nickel, nickel/phosphorous alloy, tin and silver deposits obtained was as is indicated in Table 6. Pulse durations, cathodic peak current densities of the cathodic pulse current section and current densities of direct current were as is also indicated in Table 6. The average current density of Example 14 was 15 A/dm² and thus corresponded to the direct current density of Example 15. The plating baths used for preparing the nickel, nickel/phosphorous alloy, tin, and silver deposits as well as the conditions used for preparing these deposits were as is described for Examples 1, 2, 3, 4 herein above.

After the deposits were prepared, the coated plates were heat treated for 1 h at 150 °C. Thereafter, the plates were clamped into the screw type whisker jig and loaded with 0.3 Nm for 1 week at room temperature. Formation of whiskers was subsequently evaluated as described in Comparative Examples 1 and 2. The results are as well shown in Table 5.

It turns out that when comparing Sₘₑₐₙ of comparative Example15 with Sₘₑₐₙ of the Example 14 according to the invention, considerable improvement in avoiding pressure induced whisker formation can be achieved by performing tin deposition by pulse plating instead of using direct current. When comparing Sₘₑₐₙ of Example 12 with Sₘₑₐₙ of Example14 of the Invention, further improvement in avoiding pressure induced whisker can be obtained by additionally electroplating the tin layer with a silver top layer.

**Table 5:**

| Ex. | | Underlayer 1 | Underlayer 2 | Tin Layer | Top layer | Sₘₑₐₙ / [µm] |
|---|---|---|---|---|---|---|
| 12 | inventive | Ni | NiP (≈ 12 wt.-% P) | Sn | ./. | 21.2 |
| 13 | comparative | Ni | NiP (≈ 12 wt.-% P) | Sn | ./. | 24.9 |
| 14 | inventive | Ni | NiP (≈ 12 wt.-% P) | Sn | Ag | 13.4 |
| 15 | comparative | Ni | NiP (≈ 12 wt.-% P) | Sn | Ag | 27.2 |

**Table 6:**

| | Underlayer 1 | Underlayer 2 | Tin Layer | Tin Layer Pulse plating | | Tin Layer | Top layer |
|---|---|---|---|---|---|---|---|
| Ex. | Ni Thickness | NiP Thickness | Direct current Current Density | Pulse durations (cath./zero curr.) | Cath. Peak Current Density | Sn Thickness | Ag Thickness [µm] |
| 12 | 1.5 µm | 0.1 µm | --- | 1 s / 1 s | 30 A/dm² | 3 µm | ./. |
| 13 | 1.5 µm | 0.1 µm | 15 A/dm² | --- | --- | 3 µm | ./. |
| 14 | 1.5 µm | 0.1 µm | --- | 1 s / 1 s | 30 A/dm² | 3 µm | 0.1 µm |
| 15 | 1.5 µm | 0.1 µm | 15 A/dm² | --- | --- | 3 µm | 0.1 µm |

| | | | | | | | |
|---|---|---|---|---|---|---|---|
| "Ex." means Example, "./." means not deposited, "---" means: not applied. | | | | | | | |

### Example 16A, 16B, 17A, 17B:

Several specimen of copper plates were pretreated as described herein before and plated with the respective metal deposits in the same manner as the samples of Example 8 (nickel deposit, nickel/phosphorous alloy deposit, tin deposit). The copper plates were plated under the conditions as shown in Table 7. Pulse durations were varied; the average current density was 15 A/dm² for all Examples. Thickness of the nickel, nickel/phosphorous, and tin deposit obtained was as is indicated in Table 7. Pulse durations and cathodic peak current densities of the cathodic pulse current section for tin electroplating were as is also indicated in Table 7. The compositions of the plating liquids and plating conditions were as is described for Examples 1, 2, 3, 4 herein above.

After plating the tin layer, the coated plates were heat treated for 1 h at 150 °C. Thereafter the plates were clamped into the screw type whisker jig and loaded with 0.3 Nm for 1 week at room temperature. Due to this treatment a number of pressure induced whiskers were formed. These whiskers were evaluated similarly as is described in Examples 1 and 2.

It turned out that the mean shorting lengths Sₘₑₐₙ of the Examples according to the Invention 16A and 16B were in the same range as for Example 3 and Example 8. In contrast, the mean shorting lengths Sₘₑₐₙ of the comparative Examples 17A and 17B were significantly higher; Sₘₑₐₙ of Example 17A was about 65% higher and Sₘₑₐₙ of Example 17B was about 85% higher.

**Table 7:**

| | | Underlayer 1 | Underlayer 2 | Tin Layer | | |
|---|---|---|---|---|---|---|
| Ex. | | Ni Thickness | NiP Thickness (≈ 12 wt.-% P) | Pulse durations (cath./zero curr.) | Cath. Peak Current Density | Sn Thickness |
| 16A | inventive | 1.5 µm | 0.1 µm | 1 s / 1 s | 30 A/dm² | 3 µm |
| 16B | inventive | 1.5 µm | 0.1 µm | 0.5s / 0.5s | 30 A/dm² | 3 µm |
| 17A | comparative | 1.5 µm | 0.1 µm | 60ms / 40ms | 16.7 A/dm² | 3 µm |
| 17B | comparative | 1.5 µm | 0.1 µm | 90ms / 10ms | 25 A/dm² | 3 µm |

| | | | | | | |
|---|---|---|---|---|---|---|
| "Ex." means Example. | | | | | | |

### Reference Signs

- 10: screw type whisker jig
- 11: base plate
- 12: holding structure
- 13: guiding element
- 14: lead-through opening
- 15: retaining bracket
- 16: threaded hole
- 17: threaded bolt
- 18: front face of the indenter
- 20: indenter
- 21: indenter tip
- A: smooth area, indentation
- C: semicircle
- P: plate sample
- R: ridge
- S: shorting length
- Sₘₑₐₙ: mean shorting length
- Sn: tin layer

## Claims

1. A method of depositing a tin layer on a metal substrate, said method comprising:
(a) providing said metal substrate;
(b) depositing a nickel/phosphorous alloy underlayer on at least one surface of said metal substrate;
(c) depositing said tin layer on said nickel/phosphorous alloy underlayer, wherein said tin layer is deposited comprising using a pulse plating method, wherein said pulse plating method is a unipolar pulse plating method, said unipolar pulse plating method comprising successive pulse periods each comprising a cathodic pulse section and a zero current pulse section, and wherein said cathodic pulse section has a cathodic pulse duration of at least 0.1 s and wherein said zero current pulse section has a zero current pulse duration of at least 0.1 s; wherein
said method further comprises:
(b1) depositing a nickel underlayer on said at least one surface of said substrate prior to depositing said tin layer in said method step (c) and
that said nickel underlayer is deposited prior to depositing said nickel/phosphorous alloy underlayer in said method step (b); and
(d) depositing a silver or silver alloy top layer on said tin layer.

2. The method of claim 1, **characterized in that** said nickel/phosphorous alloy underlayer comprises phosphorous at a phosphorous content of from 5 % by weight to 15 % by weight.

3. The method of any one of claims 1 or 2, **characterized in that** method steps (b1), (b) comprise depositing a double layer comprising the nickel underlayer and the nickel/phosphorous alloy underlayer, with said double layer having a thickness of from 0.01 µm to 10 µm.

4. The method of claim 3, **characterized in that** said method steps (b), (b1) comprise depositing said double layer having a thickness of from 0.05 µm to 5 µm.

5. The method of claim 1, **characterized in that** method step (d) comprises depositing said silver or silver alloy top layer at a thickness of from 0.01 µm to 0.5 µm.

6. The method of any one of the preceding claims, **characterized in that** method step (c) comprises depositing said tin layer at a layer thickness of from 0.1 µm to 10 µm.

7. The method of any one of the preceding claims, **characterized in that** said cathodic pulse section has a cathodic current pulse duration of from 0.1 s to 10 s and said zero current pulse section has a zero current pulse duration of from 0.1 s to 10 s.

8. The method of any one of the preceding claims, **characterized in that** the frequency of said unipolar pulse plating method is from 0.05 s⁻¹ to 5 s⁻¹.

9. The method of any one of the preceding claims, **characterized in that** said cathodic pulse section has a cathodic pulse peak current density of from 1 A/dm² to 60 A/dm².

10. The method of any one of the preceding claims, **characterized in that** the tin layer is free of pressure induced whiskers and that being free of pressure induced whiskers of the tin layer is determined by subjecting said tin layer to a mechanical force at a predetermined pressure for a predetermined period of time.

11. The method of claim 10, **characterized in that** the predetermined pressure ranges from 0.001 Nm to 100 Nm and the predetermined period of time ranges from 1 min to the end of the life time of the plated substrate.

12. Use of the method according to claims 1 to 11 for the manufacture of electronic circuits in electronic devices having a tin layer free of pressure induced whiskers, determined by subjecting said tin layer to a mechanical force at a predetermined pressure for a predetermined period of time.

## Patentansprüche

1. Verfahren zum Aufbringen einer Zinnschicht auf ein Metallsubstrat, wobei das Verfahren Folgendes umfasst:
(a) Bereitstellen des Metallsubstrats;
(b) Aufbringen einer Unterschicht aus Nickel-Phosphor-Legierung auf mindestens eine Oberfläche des Metallsubstrats;
(c) Aufbringen der Zinnschicht auf die Unterschicht aus Nickel-Phosphor-Legierung, wobei die Zinnschicht unter Verwendung eines Pulsplattierungsverfahrens aufgebracht wird, wobei es sich bei dem Pulsplattierungsverfahren um ein unipolares Pulsplattierungsverfahren handelt, wobei das unipolare Pulsplattierungsverfahren aufeinanderfolgende Pulszeiträume umfasst, die jeweils einen Kathodenpulsabschnitt und einen Nullstrompulsabschnitt umfassen und wobei der Kathodenpulsabschnitt eine Kathodenpulsdauer von mindestens 0,1 s aufweist und wobei der Nullstrompulsabschnitt eine Nullstrompulsdauer von mindestens 0,1 s aufweist; wobei
das Verfahren ferner Folgendes umfasst:
(b1) Aufbringen einer Unterschicht aus Nickel auf die mindestens eine Oberfläche des Substrats vor dem Aufbringen der Zinnschicht in dem Verfahrensschritt (c) und
die Unterschicht aus Nickel vor dem Aufbringen der Unterschicht aus Nickel-Phosphor-Legierung in dem Verfahrensschritt (b) aufgebracht wird; und
(d) Aufbringen einer Deckschicht aus Silber oder Silberlegierung auf die Zinnschicht.

2. Verfahren nach Anspruch 1, **dadurch gekennzeichnet, dass** die Unterschicht aus Nickel-Phosphor-Legierung Phosphor mit einem Phosphorgehalt von 5 Gew.-% bis 15 Gew.-% umfasst.

3. Verfahren nach einem der Ansprüche 1 oder 2, **dadurch gekennzeichnet, dass** die Verfahrensschritte (b1), (b) das Aufbringen einer Doppelschicht umfassen, die die Unterschicht aus Nickel und die Unterschicht aus Nickel-Phosphor-Legierung umfasst, wobei die Doppelschicht eine Dicke von 0,01 µm bis 10 µm aufweist.

4. Verfahren nach Anspruch 3, **dadurch gekennzeichnet, dass** die Verfahrensschritte (b), (b1) das Aufbringen der Doppelschicht mit einer Dicke von 0,05 µm bis 5 µm umfasst.

5. Verfahren nach Anspruch 1, **dadurch gekennzeichnet, dass** Verfahrensschritt (d) das Aufbringen der Deckschicht aus Silber oder Silberlegierung in einer Dicke von 0,01 µm bis 0,5 µm umfasst.

6. Verfahren nach einem der vorstehenden Ansprüche, **dadurch gekennzeichnet, dass** Verfahrensschritt (c) das Aufbringen der Zinnschicht in einer Schichtdicke von 0,1 µm bis 10 µm umfasst.

7. Verfahren nach einem der vorstehenden Ansprüche, **dadurch gekennzeichnet, dass** der Kathodenpulsabschnitt eine Kathodenstrompulsdauer von 0,1 s bis 10 s aufweist und der Nullstrompulsabschnitt eine Nullstrompulsdauer von 0,1 s bis 10 s aufweist.

8. Verfahren nach einem der vorstehenden Ansprüche, **dadurch gekennzeichnet, dass** die Frequenz des unipolaren Pulsplattierungsverfahrens 0,05 s⁻¹ bis 5 s⁻¹ beträgt.

9. Verfahren nach einem der vorstehenden Ansprüche, **dadurch gekennzeichnet, dass** der Kathodenpulsabschnitt eine Kathodenstrompuls-Peakdichte von 1 A/dm² bis 60 A/dm² aufweist.

10. Verfahren nach einem der vorstehenden Ansprüche, **dadurch gekennzeichnet, dass** die Zinnschicht frei von druckinduzierten Whiskern ist und das Freisein der Zinnschicht von druckinduzierten Whiskern bestimmt wird, indem die Zinnschicht einer mechanischen Kraft bei einem vorab festgelegten Druck über einen vorab festgelegten Zeitraum hinweg unterzogen wird.

11. Verfahren nach Anspruch 10, **dadurch gekennzeichnet, dass** der vorab festgelegte Druck im Bereich von 0,001 Nm bis 100 Nm liegt und der vorab festgelegte Zeitraum im Bereich von 1 min bis zum Ende der Lebensdauer des plattierten Substrats liegt.

12. Verwendung des Verfahrens nach einem der Ansprüche 1 bis 11 zur Herstellung elektronischer Schaltungen in elektronischen Vorrichtungen, die eine Zinnschicht aufweisen, die frei von druckinduzierten Whiskern ist, was bestimmt wird, indem die Zinnschicht einer mechanischen Kraft bei einem vorab festgelegten Druck über einen vorab festgelegten Zeitraum hinweg unterzogen wird.

## Revendications

1. Procédé de dépôt d'une couche d'étain sur un substrat métallique, ledit procédé comprenant :
(a) la mise à disposition dudit substrat métallique ;
(b) le dépôt d'une sous-couche d'alliage de nickel/phosphore sur au moins une surface dudit substrat métallique ;
(c) le dépôt de ladite couche d'étain sur ladite sous-couche d'alliage de nickel/phosphore, ladite couche d'étain étant déposée en comprenant l'utilisation d'un procédé de placage pulsé,
ledit procédé de placage pulsé étant un procédé de placage pulsé unipolaire, ledit procédé de placage pulsé unipolaire comprenant des périodes d'impulsions successives comprenant chacune une section d'impulsions cathodiques et une section d'impulsions à courant nul, et ladite section d'impulsions cathodiques possédant une durée d'impulsions cathodiques d'au moins 0,1 s et ladite section d'impulsions à courant nul possédant une durée d'impulsions à courant nul d'au moins 0,1 s ;
ledit procédé comprenant en outre :
(b1) le dépôt d'une sous-couche de nickel sur ladite au moins une surface dudit substrat avant le dépôt de ladite couche d'étain dans ladite étape de procédé (c) et
cette dite sous-couche de nickel étant déposée avant le dépôt de ladite sous-couche d'alliage de nickel/phosphore dans ladite étape de procédé (b) ; et
(d) le dépôt d'une couche supérieure d'argent ou d'alliage d'argent sur ladite couche d'étain.

2. Procédé selon la revendication 1, **caractérisé en ce que** ladite sous-couche d'alliage de nickel/phosphore comprend du phosphore à raison d'une teneur en phosphore allant de 5 % en poids à 15 % en poids.

3. Procédé selon l'une quelconque des revendications 1 et 2, **caractérisé en ce que** les étapes de procédé (b1), (b) comprennent le dépôt d'une couche double comprenant la sous-couche de nickel et la sous-couche d'alliage de nickel/phosphore, ladite couche double possédant une épaisseur allant de 0,01 µm à 10 µm.

4. Procédé selon la revendication 3, **caractérisé en ce que** lesdites étapes de procédé (b), (b1) comprennent le dépôt de ladite couche double possédant une épaisseur allant de 0,05 µm à 5 µm.

5. Procédé selon la revendication 1, **caractérisé en ce que** l'étape de procédé (d) comprend le dépôt de ladite couche supérieure d'argent ou d'alliage d'argent à raison d'une épaisseur allant de 0,01 à 0,5 µm.

6. Procédé selon l'une quelconque des revendications précédentes, **caractérisé en ce que** l'étape de procédé (c) comprend le dépôt de ladite couche d'étain à raison d'une épaisseur de couche allant de 0,1 µm à 10 µm.

7. Procédé selon l'une quelconque des revendications précédentes, **caractérisé en ce que** ladite section d'impulsions cathodiques possède une durée d'impulsions de courant cathodique allant de 0,1 s à 10 s et ladite section d'impulsions à courant nul possède une durée d'impulsions à courant nul allant de 0,1 s à 10 s.

8. Procédé selon l'une quelconque des revendications précédentes, **caractérisé en ce que** la fréquence dudit procédé de placage par impulsions unipolaires est de 0, 05 s⁻¹ à 5 s⁻¹.

9. Procédé selon l'une quelconque des revendications précédentes, **caractérisé en ce que** ladite section d'impulsions cathodiques possède une densité de courant maximale d'impulsions cathodiques allant de 1 A/dm² à 60 A/dm².

10. Procédé selon l'une quelconque des revendications précédentes, **caractérisé en ce que** la couche d'étain est exempte de trichites induites par la pression et **en ce que** le fait que la couche d'étain soit exempte de trichites induites par la pression est déterminé en soumettant ladite couche d'étain à une force mécanique à une pression prédéterminée pendant une période de temps prédéterminée.

11. Procédé selon la revendication 10, **caractérisé en ce que** la pression prédéterminée se situe dans la plage de 0,001 Nm à 100 Nm et la période de temps prédéterminée se situe dans la plage de 1 min à la fin du temps de vie du substrat plaqué.

12. Utilisation du procédé selon les revendications 1 à 11 pour la fabrication de circuits électroniques dans des dispositifs électroniques possédant une couche d'étain exempte de trichites induites par la pression, déterminée en soumettant ladite couche d'étain à une force mécanique à une pression prédéterminée pendant une période de temps prédéterminée.
